Europäisches Patentamt

European Patent Office

Office européen des brevets

(19)

(11) EP 0 771 093 A2

(12) EUROPEAN PATENT APPLICATION

(43) Date of publication:
02.05.1997 Bulletin 1997/18

(51) Int Cl.⁶: H04L 7/02

(21) Application number: 96440090.7

(22) Date of filing: 21.10.1996

(84) Designated Contracting States:
DE FR GB IT

(30) Priority: 27.10.1995 ES 9502096

(71) Applicant: ALCATEL ALSTHOM COMPAGNIE
GENERALE D'ELECTRICITE
75382 Paris Cédex 08 (FR)

(72) Inventors:
• Rodriguez Martinez, Maria Africa
28005 Madrid (ES)
• Mari Mari, Juan Jose
28030 Madrid (ES)

(74) Representative: Pohl, Herbert, Dipl.-Ing. et al
Alcatel Alsthom,
Postfach 30 09 29
70449 Stuttgart (DE)

(54) **Signal interpolator for timing recovery**

(57)     Interpolator for obtaining intermediate values between two consecutive samples of a signal, particularly applicable to high speed data acquisition systems and demodulators.

It comprises delay means (T) which delay the incoming signal (X0) N times to obtain N+1 samples (X0,X1,X2,X3); data storage means (F0,F1,F2,F3) that receive each of them one of the N+1 samples (X0,X1,X2,X3) and the value of the fraction of the time interval ($\mu$) and generate N+1 outputs (X0',X1',X2',X3'); and adding means (SUM) that adds the N+1 outputs (X0',X1',X2',X3') from the data storage means (F0,F1,F2,F3), and outputs an interpolated value (X).

Each data storage means (F0,F1,F2,F3) contains a table of values, such that the output values from each of them (X0',X1',X2',X3') are a function of the input values taken in each case by the fraction of the time interval ($\mu$)and of the value of its corresponding sample (X0,X1,X2,X3).

Fig. 2

EP 0 771 093 A2

**Description**

<u>OBJECT OF THE INVENTION</u>

This invention concerns a signal interpolator for obtaining intermediate values between two consecutive samples of a signal. This interpolator is particularly useful in timing recovery for demodulators and data acquisition systems in general working at high speed.

<u>BACKGROUND OF THE INVENTION</u>

In every demodulator and data acquisition system in general, there has to be synchronism between the sampling clock and the incoming data signal for the data to be detected in optimum conditions. Actually the bit rate of the received data does not coincide exactly with a submultiple of the sampling frequency, consequently problems arise in synchronising the sampling clock frequency and the received data rate.

To avoid this problem, what has been done normally is to vary the sampling clock frequency as a function of the received data rate and thereby correct any synchronisation error that arose. This solution, as a mechanism for adjusting clock synchronisation in the receiver by altering the sampling clock is suitable in some cases, for example for low speed data. But for certain systems this solution does not work since the variation in the sampling frequency induces errors in the subsequent data recognition process. This is the case in digital processing systems for frequency-multiplexed asynchronous signals or in asynchronous digital data-capture systems with subsequent signal processing. The same thing happens in high speed data acquisition systems, working at more than 2 Mb/s for example.

In these cases, in which the sampling clock has to be independent of variations in the data rate, what has normally been done is to employ interpolation techniques to obtain intermediate values between two consecutive samples, increasing the sampling rate through digital signal processing.

Thus, the adjustment in timing in reception is done on the incoming data signal, not on the receiver's local clock, since, starting from a greater number of non-synchronised samples taken in such a way and by means of subsequent signal processing, the values obtained correspond to the signal samples that would be obtained if the sampling clock were in synchronism with the incoming data signal.

The application of interpolation techniques for timing recovery in data acquisition systems is well known and widely documented. An example of the implementation of interpolation in modems is to be found in the article "Interpolation in digital modems - Part I: Fundamentals" by Floyd M. Gardner in the IEEE Transactions on Communications, vol. 41, No. 3, March 1993, pages 501-507.

This solution, however, greatly increases the number of operations that have to be done, with the accompanying increase in complexity in the implementation and with the corresponding increase in power consumption, making it not easy to integrate into circuits using present VLSI technology.

<u>CHARACTERISATION OF THE INVENTION</u>

This invention presents an interpolator for obtaining intermediate values between two consecutive samples of a signal, which comprises delay means that delay the incoming signal N times, thereby obtaining N+1 samples; data storage means which, depending on the value taken by their corresponding signal sample and on the value of the fraction of the time interval, generate N+1 outputs of digitally stored values; and adding means which adds the N+1 outputs of the data storage means to produce the final interpolated value.

The value which in each case is taken by the time interval fraction determines the contribution of each of the N+1 samples in the final interpolated value.

The advantages of using this interpolator rest in a reduction in both the number of operations to be carried out and in the complexity of its implementation, since it is easy to integrate using present VLSI technology and suitable for demodulator and data acquisition systems in general working at high speed.

<u>BRIEF FOOTNOTES TO THE FIGURES</u>

A fuller explanation of the invention can be obtained from the description provided below of a preferred implementation based on the figures attached in which:

- figure 1 shows the series of samples of the data signal obtained at determined time instants, starting from which values are obtained between two consecutive samples, by means of interpolation techniques, and
- figure 2 shows the configuration of the interpolator object of this invention, for obtaining intermediate values between two consecutive samples.

**DESCRIPTION OF A PREFERRED IMPLEMENTATION**

As has already been stated, the synchronisation adjustment in reception is made by means of interpolation techniques in those systems in which it is not possible to alter the sampling frequency without impairing the subsequent data recognition process.

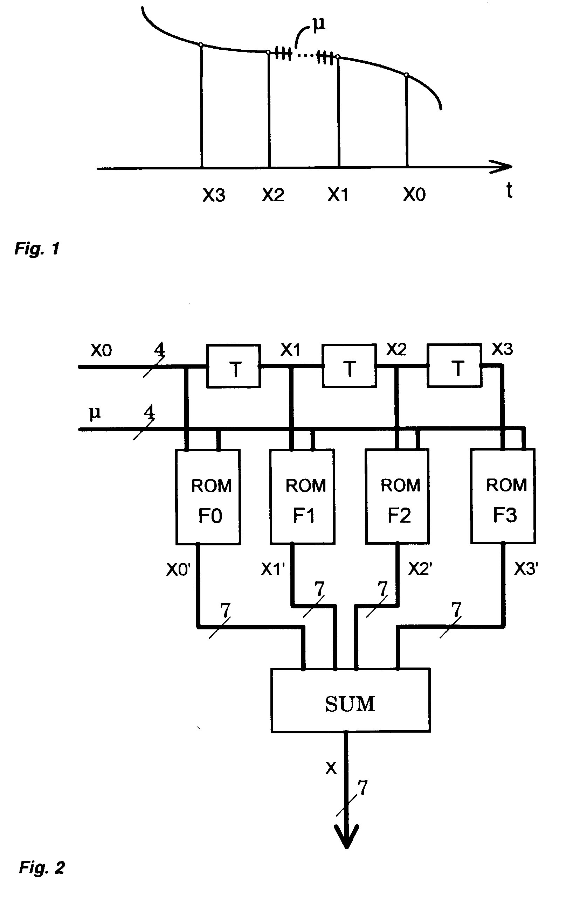

Figure 1 illustrates a data signal for which, by making use of a third order interpolating polynomial in this preferred implementation, values are obtained between the four consecutive samples of the signal, each sample being taken with one time interval difference with respect to the preceding one X0, X1, X2, X3, where $\mu$ represents the value of each of the sixteen fractions into which the time interval between two consecutive samples is divided.

Considering $\{a_k\}$ to be the coefficients of the third order polynomial function, the resulting interpolated value is given by the following expression:

$$x = \sum_{k=0}^{3} a_k t^k$$

where $t^k$ are the values of the time instants of the samples which, in the case in question, is equivalent to the fraction of the time interval $\mu$ into which the time interval between two consecutive samples is divided.

The coefficients of the polynomial $a_k$ are, in turn, a function of the values of the signal samples X at the starting points considered for the interpolation

$$a_k = \sum_{i=1}^{3} x_i b_{ki}$$

where $b_{ki}$ are constants the values of which depend on the sampling instants and which determine the weight of each of the factors in the polynomial.

As a result, the starting expression can be written in the following form:

$$X \equiv X(\mu) = \sum_{k=0}^{3} \left( \sum_{i=0}^{3} X_i b_{ki} \right) \mu^k = \sum_{i=0}^{3} \sum_{k=0}^{3} b_{ki} \mu^k X_i$$

$$X(\mu) = \sum_{i=0}^{3} F_i(\mu) X_i$$

where

$$F_i(\mu) = \sum_{k=0}^{3} b_{ki} \mu^k$$

Developing this expression for the output signal for this cubic interpolation, one obtains:

$$X = F0(X0,\mu) + F1(X1,\mu) + F2(X2,\mu) + F3(X3,\mu)$$

where

$$F0(X0,\mu) = X0 * (b00 + \mu * b10 + \mu^2 * b20 + \mu^3 * b30)$$

$$F1\,(X1,\mu) = X1 * (b01 + \mu * b11 + \mu^2 * b21 + \mu^3 * b31)$$

$$F2\,(X2,\mu) = X2 * (b02 + \mu * b12 + \mu^2 * b22 + \mu^3 * b32)$$

$$F3\,(X3,\mu) = X3 * (b03 + \mu * b13 + \mu^2 * b23 + \mu^3 * b33)$$

This permits the total output to be expressed as the sum of four functions $F0(X0,\mu)$, $F1(X1,\mu)$, $F2(X2,\mu)$ and $F3(X3,\mu)$ the values of which depend, respectively, on each of the sampled values and on the value of the fraction of the time interval in which it is desired to obtain the interpolated value.

Figure 2 is a diagram of the interpolator object of this invention which implements the above functions. This interpolator consists of delay means formed by three shift registers T which delay the input signal X0 in such a way that four signal samples X0,X1,X2,X3 are obtained, each one of which is delayed by one sample period with respect to the preceding one.

Both the input signal X0 and the fraction of the times interval $\mu$ are encoded with four bits in such a way that each of the signal samples X0, X1, X2, X3, together with the value in each case of the fraction of the time interval $\mu$, act, respectively, as input to data storage means F0, F1, F2, F3 formed by a set of four read-only memories F0, F1, F2, F3 of 256 bytes each.

Each of these read-only memories, ROM, store the values of a third order polynomial function $F0(X0, \mu)$, $F1(X1, \mu)$, $F2(X2, \mu)$ and $F3(X3, \mu)$, for the possible 16 values of $\mu$ and X, respectively, that can appear at their inputs. In this way, the necessary mathematical operations are carried out beforehand and stored in the form of tables that are addressed by the variables, there being no need for continuous calculations.

These memories produce four outputs X0', X1', X2', X3' of seven bits each, which are added in the adder SUM, to produce the final interpolated value X. Since each of the four elements added has seven bits, the true size of the sum should be nine bits, however through a process of truncation its magnitude is reduced to seven bits by the elimination of the two bits with least weight.

## Claims

1. **INTERPOLATOR** for obtaining intermediate values between two consecutive samples of a signal, **<u>characterised</u>** in that it comprises:

   a) delay means which delay the input signal (X0), in such a way that N+1 samples (X0,X1,X2,X3) are obtained, each one being delayed by one sample period with respect to the preceding one;
   b) data storage means (F0,F1,F2,F3) each of which receives its corresponding sample of the N+1 samples (X0,X1,X2,X3), in each case together with the value of the fraction of the time interval ($\mu$) in which the interpolation is made, as a function of which these storage means produce N+1 outputs (X0',X1',X2',X3'); and
   c) adding means (SUM) which adds the N+1 outputs (X0',X1',X2',X3') from the data storage means (F0,F1,F2,F3), producing thereby a final interpolated value (X).

2. **INTERPOLATOR** according to claim 1, **<u>characterised</u>** in that the value which in each case is taken by the fraction of the time interval ($\mu$) determines the contribution of each of the N+1 samples (X0,X1,X2,X3) to the final interpolated value (X), as a function of the distance of each of the N+1 samples (X0,X1,X2,X3) from the instant at which it is desired to obtain this final interpolated value (X).

3. **INTERPOLATOR** according to claim 1, **<u>characterised</u>** in that each data storage means (F0,F1,F2,F3) contains tables of values previously stored in digital form, such that the output values from each of them (X0',X1',X2',X3') are a function of the input values taken in each case by the fraction of the time interval ($\mu$) and of the value of its corresponding sample of the N+1 samples (X0,X1,X2,X3).

Fig. 1

Fig. 2